(19) Europäisches Patentamt
European Patent Office
Office européen des brevets

(11) Veröffentlichungsnummer: **0 019 123**
**B1**

(12) # EUROPÄISCHE PATENTSCHRIFT

(45) Veröffentlichungstag der Patentschrift: **12.10.83**

(51) Int. Cl.³: **G 03 F 7/00**, G 03 C 1/70

(21) Anmeldenummer: **80102260.9**

(22) Anmeldetag: **25.04.80**

(54) **Verfahren zur phototechnischen Herstellung von Reliefstrukturen.**

(30) Priorität: **16.05.79 DE 2919840**

(43) Veröffentlichungstag der Anmeldung: **26.11.80 Patentblatt 80/24**

(45) Bekanntmachung des Hinweises auf die Patenterteilung: **12.10.83 Patentblatt 83/41**

(84) Benannte Vertragsstaaten: **AT BE CH DE FR GB IT LI NL SE**

(56) Entgegenhaltungen:
**DE-C-2 437 348**
**US-A-3 485 732**

(73) Patentinhaber: **SIEMENS AKTIENGESELLSCHAFT, Berlin und München Wittelsbacherplatz 2, D-8000 München 2 (DE)**

(72) Erfinder: **Rubner, Roland, Dr., Buchenring 15, D-8551 Röttenbach (DE)**
Erfinder: **Kühn, Eberhard, Bergstrasse 32, D-8551 Hemhofen (DE)**
Erfinder: **Ahne, Hellmut, Dr., Heidestrasse 6, D-8551 Röttenbach (DE)**

EP 0 019 123 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Verfahren zur phototechnischen Herstellung von Reliefstrukturen

Die Erfindung betrifft ein Verfahren zur phototechnischen Herstellung von Reliefstrukturen aus acrylat- und/oder methacrylatgruppenhaltige Polymere und Photoinitiatoren enthaltenden Gemischen.

Eines der genauesten Strukturierungsverfahren für Isolierstoffe, Halbleiter- und Leiterwerkstoffe in der Elektrotechnik ist die Phototechnik. Hierbei werden phototechnisch erzeugte Resist-Reliefstrukturen durch geeignete Prozesse, wie Ätzen, Bedampfen und stromloses oder galvanisches Metallisieren, auf Substrate kopiert. Resist-Reliefstrukturen können weiterhin auch eine dauerhafte Schutzfunktion, beispielsweise als Isolierstoff, übernehmen.

Bei einem aus der DE-C-2 437 348 bekannten Verfahren werden Reliefstrukturen aus hochwärmebeständigen Polymeren hergestellt. Dazu werden strahlungsempfindliche lösliche polymere Vorstufen in Form einer Schicht oder Folie auf ein Substrat aufgetragen, die strahlungsempfindliche Schicht oder Folie wird dann durch Negativvorlagen bestrahlt und anschliessend werden die nicht bestrahlten Schicht- oder Folienteile vom Substrat entfernt; erforderlichenfalls kann sich hieran noch eine Temperung der erhaltenen Relierstruktur anschliessen. Als lösliche polymere Vorstufen werden bei diesem Verfahren Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Oxyalkyl-acrylat- oder -methacrylatgruppen.

Die Lichtempfindlichkeit von Resistmaterialien, wie photoreaktiven Polymeren, kann durch den Zusatz von Photoinitiatoren und Photosensibilisatoren erhöht werden. Dies ist deshalb von Bedeutung, weil für die Wirtschaftlichkeit der phototechnischen Strukturierung von Oberflächen eine möglichst kurze Belegung der teuren Belichtungseinrichtungen, d.h. eine möglichst hohe Empfindlichkeit der verwendeten Photoresists, gefordert wird. Beim bekannten Verfahren werden den polymeren Vorstufen deshalb Verbindungen wie Michlers Keton, d.h. 4,4'-Bis(dimethylamino)-benzophenon, Benzoinäther, 2-tert. Butyl-9,10-authrachinon, 1,2-Benz-9,10-anthrachinon und Bis(diäthylamino)-benzophenon zugesetzt. Zur Steigerung der Lichtempfindlichkeit können den polymeren Vorstufen auch copolymerisierbare, strahlungsempfindliche Maleinimide beigefügt werden.

Aufgabe der Erfindung ist es, die Photoreaktivität von Gemischen, die acrylat- und/oder methacrylatgruppenhaltige Polymere und Photoinitiatoren enthalten, weiter zu erhöhen, um auf diese Weise die phototechnischen Herstellung von Reliefstrukturen noch rationeller zu gestalten.

Dies wird erfindungsgemäss dadurch erreicht, dass als Photoinitiatoren maleinimidgruppenfreie aromatische Azide verwendet werden. Mit dem Begriff «aromatisch» werden im Rahmen der vorliegenden Patentanmeldung Benzolderivate bezeichnet, einschliesslich anellierter, d.h. kondensierter Ringsysteme.

Das erfindungsgemässe Verfahren gestattet die rationelle Erzeugung vernetzter organischer Reliefstrukturen durch kurzzeitige selektive Bestrahlung von Filmschichten und nachfolgendes Herauslösen der unbelichteten Filmteile. Dies ist möglich, weil die acrylat- bzw. methacrylatgruppenhaltigen Polymeren durch den Zusatz von Aziden photoreaktiver werden.

Als Photoinitiatoren können beispielsweise folgende Verbindungen verwendet werden: 4,4'-Diazidostilben, 4,4'-Diazidobenzophenon, 4,4'-Diazidodibenzalaceton und 2,6-Di-(4'-azidobenzal)-4-methyl-cyclohexanon. Vorzugsweise werden beim erfindungsgemässen Verfahren Sulfonylazide verwendet, beispielsweise Phenylsulfonylazid, p-Methoxyphenylsulfonylazid, p-Acetamidophenylsulfonylazid und 1- bzw. 2-Naphthylsulfonylazid. Diese Verbindungen sind thermisch besonders stabil und erlauben somit einen weiten Verarbeitungsspielraum.

Dem photoreaktiven Gemisch können vorteilhaft ferner Sensibilisatoren, wie Michlers Keton, und Maleinimide, insbesondere N-Phenylmaleinimid, zugesetzt werden. Auf diese Weise kann die Lichtempfindlichkeit des Gemisches noch weiter erhöht werden.

Die Verwendung von Aziden als Photoinitiatoren für Resists, insbesondere Negativresists, ist zwar an sich bekannt. Bislang wurden Azide allerdings lediglich bei Diallylphthalat-Prepolymeren, Polyisoprenharzen und Polyvinylcinnamaten eingesetzt (siehe: W.S. DeForest «Photoresist», McGraw-Hill Book Company, 1975, Seite 35 bis 41). Die Tatsache, dass sich diese Verbindungsklasse auch zur Verwendung bei acrylat- und methacrylatgruppenhaltigen Polymeren eignet, war aber durchaus überraschend und konnte nicht vorhergesehen werden. Im Gegensatz zu Diallylphthalat-Prepolymeren, Polyisoprenharzen und Polyvinylcinnamaten sind nämlich acrylat- und methacrylatgruppenhaltige Harze von Natur aus wesentlicher reaktiver, so dass es sehr überraschend war, dass sie in Gegenwart von Aziden (noch) handhabbar sind.

Anhand von Beispielen soll die Erfindung noch näher erläutert werden.

Beispiel 1 (Vergleichsversuch)

Aus Pyromellithsäuredianhydrid, Methacrylsäure-2-hydroxyäthylester und 4,4'-Diaminodiphenyläther wird – gemäss DE-PS 2 437 348 – eine lösliche polymere Vorstufe in Form eines Polyamidocarbonsäuremethacrylats folgender Struktur

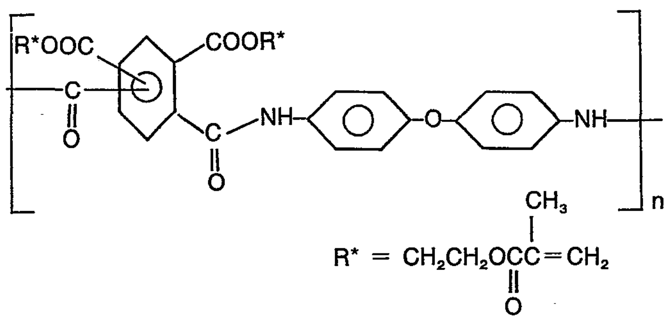

hergestellt (Methacrylatharz).

10 Gewichtsteile des Methacrylharzes werden zusammen mit 0,5 Gewichtsteilen N-Phenylmaleinimid und 0,2 Gewichtsteilen Michlers Keton in 22 Volumteilen eines Gemisches von Dimethylacetamid und Dioxan (Volumenverhältnis 1:1) gelöst. Die Lösung wird dann filtriert und auf Aluminiumfolien zu gleichmässigen Filmen geschleudert. Nach $1^1/_2$stündiger Trocknung von 60 °C im Vakuum beträgt die Filmstärke 6 µm. Die auf diese Weise erhaltenen Filme werden dann mit einer 500 W-Quecksilberhöchstdrucklampe durch eine Kontaktkopie belichtet. Bei einer Belichtungszeit von 60 bis 75 s werden – nach der Entwicklung mit einem 1:1-Gemisch von γ-Butyrolacton und Toluol (Entwicklungsdauer 16 s) – kantenscharfe Reliefstrukturen mit einer Auflösung von 10 µm erhalten. Diese Muster werden 1 h bei 340 °C getempert, wobei das Auflösungsvermögen und die Kantenschärfe der Reliefstrukturen nicht beeinträchtigt werden.

Beispiel 2

10 Gewichtsteile des in Beispiel 1 beschriebenen Methacrylatharzes werden zusammen mit 0,4 Gewichtsteilen p-Acetamido-phenylsulfonylazid und 0,2 Gewichtsteilen Michlers Keton entsprechend Beispiel 1 zur Herstellung von Filmen mit einer Dicke von 6 µm eingesetzt. Mit derartigen Filmen werden bereits nach einer Belichtungszeit von 45 s, bei den in Beispiel 1 angegebenen Belichtungs- und Entwicklungsbedingungen, kantenscharfe Reliefstrukturen erhalten.

Beispiel 3

Mittels einer Reaktionslösung, die 10 Gewichtsteile des Methacrylatharzes nach Beispiel 1, 0,17 Gewichtsteile p-Acetamido-phenylsulfonylazid, 0,2 Gewichtsteile Michlers Keton und 0,13 Gewichtsteile N-Phenylmaleinimid enthält, werden auf Aluminiumfolien 6 µm starke Filme erzeugt. Bei den gleichen Belichtungs- und Entwicklungsbedingungen wie in Beispiel 1 ist auch hierbei lediglich eine Belichtungszeit von 45 s erforderlich, um aus derartigen Filmen kantenscharfe Reliefstrukturen herzustellen.

Beispiel 4 (Vergleichsversuch)

Bei einer Reaktionslösung gemäss Beispiel 1 werden anstelle von 0,2 Gewichtsteilen Michlers Keton 0,1 Gewichtsteile Benzoinisopropyläther verwendet und aus dieser Reaktionslösung Filme mit einer Dicke von 7 µm hergestellt. Bei den in Beispiel 1 angegebenen Bedingungen beträgt die zur Strukturerzeugung erforderliche Belichtungszeit 300 bis 420 s.

Beispiel 5

Aus 10 Gewichtsteilen Methacrylatharz, 0,4 Gewichtsteilen p-Acetamido-phenylsulfonylazid und 0,1 Gewichtsteilen Benzoinisopropyläther wird entsprechend Beispiel 1 eine Reaktionslösung hergestellt. Mit dieser Reaktionslösung werden Filme mit einer Dicke von 7 µm erzeugt. Bei derartigen Filmen beträgt die für die – in der geschilderten Weise durchgeführte – Strukturerzeugung erforderliche Belichtungszeit lediglich 120 s.

**Patentansprüche**

1. Verfahren zur phototechnischen Herstellung von Reliefstrukturen aus acrylat- und/oder methacrylatgruppenhaltige Polymere und Photoinitiatoren enthaltenden Gemischen, dadurch gekennzeichnet, dass als Photoinitiatoren maleinimidgruppenfreie aromatische Azide verwendet werden.

2. Verfahren nach Anspruch 1, dadurch gekennzeichnet, dass als Photoinitiatoren Sulfonylazide verwendet werden.

3. Verfahren nach Anspruch 1 oder 2, dadurch gekennzeichnet, dass dem Gemisch ein Sensibilisator, insbesondere Michlers Keton, zugesetzt wird.

4. Verfahren nach einem der Ansprüche 1 bis 3, dadurch gekennzeichnet, dass dem Gemisch ein Maleinimid, insbesondere N-Phenylmaleinimid, zugesetzt wird.

**Claims**

1. A process for the production of relief structures by a photo-technique, from mixtures containing polymers which contain acrylate groups and/or methacrylate groups and photo-initiators, characterised in that aromatic azides which are free from maleimide groups are used as photoinitiators.

2. A process as claimed in Claim 1, characterised in that sulfonyl azides are used as photoinitiators.

3. A process as claimed in Claim 1 or Claim 2, characterised in that a sensitizer, in particular Michlers ketone, is added to the mixture.

4. A process as claimed in one of Claims 1 to 3, characterised in that a maleinimide, in particular N-phenyl-maleinimide, is added to the mixture.

**Revendications**

1. Procédé de préparation phototechnique de structures en relief en utilisant les mélanges contenant des photoinitiateurs et des polymères ayant des groupes acrylate et/ou méthacrylate, caractérisé en ce qu'il consiste à utiliser, comme photoinitiateurs, des azides aromatiques exempts de groupes maléinimide.

2. Procédé suivant la revendication 1, caractérisé en ce qu'il consiste à utiliser comme photoinitiateurs des sulfonylazides.

3. Procédé suivant la revendication 1 ou 2, caractérisé en ce qu'il consiste à ajouter au mélange un sensibilisateur, notamment la cétone de Michler.

4. Procédé suivant l'une des revendications 1 à 3, caractérisé en ce qu'il consiste à ajouter au mélange un maléinimide, notamment du N-phénylmaléinimide.